**Europäisches Patentamt**

**European Patent Office**

**Office européen des brevets**

(11) Publication number: **0 080 044**
**B1**

(12) **EUROPEAN PATENT SPECIFICATION**

(45) Date of publication of patent specification: **02.03.88**

(21) Application number: **82108864.8**

(22) Date of filing: **24.09.82**

(51) Int. Cl.⁴: **H 01 L 29/743,** H 01 L 29/10, H 01 L 29/08

(54) Semiconductor device having rapid removal of majority carriers from an active base region thereof at device turn-off and method of fabricating this device.

(30) Priority: **23.11.81 US 324245**

(43) Date of publication of application:
**01.06.83 Bulletin 83/22**

(45) Publication of the grant of the patent:
**02.03.88 Bulletin 88/09**

(84) Designated Contracting States:
**DE FR GB SE**

(56) References cited:
**EP-A-0 009 367**
**EP-A-0 030 274**
**DE-A-2 804 443**
**US-A-4 089 024**
**US-A-4 240 846**
**US-A-4 275 408**

(73) Proprietor: **GENERAL ELECTRIC COMPANY**
**1 River Road**
**Schenectady New York 12305 (US)**

(72) Inventor: **Baliga, Bantval Jayant**
**3 Clove Court**
**Clifton Park New York 12065 (US)**

(74) Representative: **Kinne, Reinhard, Dipl.-Ing. et al**
**Patentanwaltsbüro Tiedtke-Bühling-Kinne-**
**Grupe-Pellmann-Grams-Struif Bavariaring 4**
**D-8000 München 2 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a semiconductor device according to the preamble of claim 1.

A semiconductor device of this type is known from EP—A—0 009 367. This known semiconductor device is a gate turn-off thyristor which conists of a semiconductor substrate of bulk type material. In the substrate is formed a NPNP four-layer structure, wherein the P-anode layer is contacted by an anode electrode and includes second regions of N-conductivity, the doping concentration of the second regions being higher than the concentration of the anode layer. Via the second regions, the anode electrode makes direct electrical contact with an active base layer adjoining the anode layer, thus short-circuiting the anode layer. This feature is known in the art as an "anode short".

From US—A—4 275 408, there is known a thyristor in which are incorporated highly doped N-regions into the active N-base region, the N-regions being in contact with the P-emitter region. This structure enables to reduce the turn-off time of the thyristor.

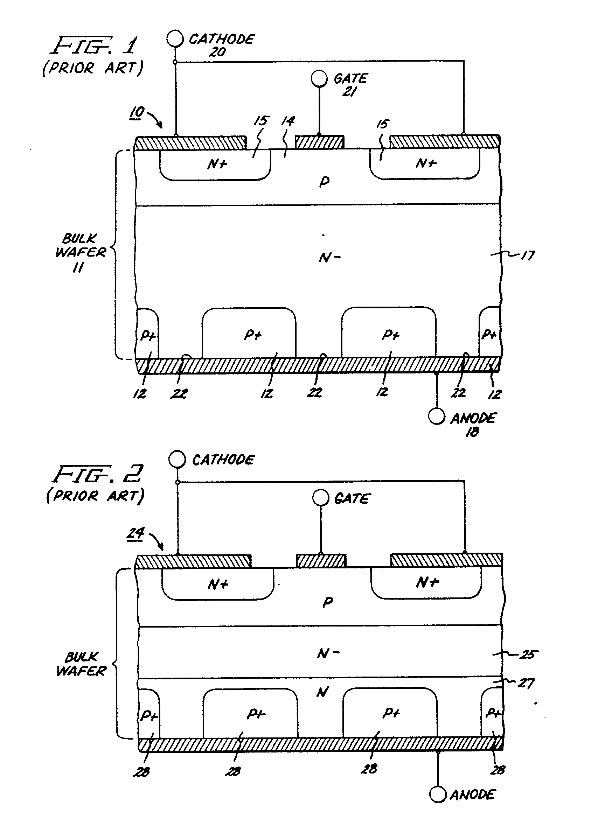

In Figure 1 is shown another prior art semiconductor device in the form of a thyristor 10. The thyristor 10 comprises a lightly doped, N-type, or "N⁻", bulk wafer 11, into which P⁺ emitter regions 12, as well as a P base region 14 and N⁺ emitter regions 15 have been diffused. The remaining N⁻ region 17 comprises an active base region. The thyristor 10 is a three terminal device, having an anode 18, a cathode 20, and a gate 21; and the operation thereof is well known in the art.

At interface regions 22 of the thyristor 10, the anode 18, which usually is metallic, makes direct electrical contact with the N⁻ active base region 17, thus forming an "anode short". It is known in the art that the metal-semiconductor interface regions 22 each typically have the characteristic of a high carrier recombination velocity. Thus, when turn-off of the thyristor 10 is initiated, majority carriers in the N⁻ active base region 17 (electrons, here) are able to rapidly recombine with holes at the interface regions 22, thereby achieving rapid removal of the majority carriers from the N⁻ active base region 17. The significance of this is that the time required for turn-off of the thyristor 10 is reduced.

In the thyristor 10, however, the width of the N⁻ active base region 17 (that is, the vertical dimension thereof in Figure 1) is quite large, relatively speaking, and typically is about 254 $\mu$m (10 mils). Having such a large active base region width enables the thyristor 10 to properly operate with, or block, relatively large voltages between the anode 18 and cathode 20, such voltages being, for example, in the order of 2000 volts. Often it occurs that a semiconductor device only needs to block a relatively low voltage, such as, by way of example, 1000 volts. The active base region width of such a low voltage device optimally is much narrower than the N⁻ active base region width of the thyristor 10, in order to reduce the voltage drop between the anode 18 and the cathode 20 during forward conduction of the thyristor 10, and, also, to reduce the required amount of semiconductor material, and, by way of example, such width can be in the order of 100 $\mu$m.

It is not practical to fabricate such low voltage semiconductor devices with narrow active base region widths solely from bulk wafers, as is the case with the thyristor 10, above, due to the inherent problems that would arise from the use of an extremely thin and thus fragile bulk wafer. Accordingly, as is known in the art, in order to fabricate such semiconductor device with narrow active base regions, it is necessary to epitaxially grow an active base region on a substrate which comprises a bulk wafer and which constitutes a highly doped region, corresponding to the P⁺ emitter regions 12 of the above thyristor 10. However, it is not possible, at least using diffusion technology, to fabricate such devices which incorporate metal-semiconductor interface regions between the active base region and the anode of the device, as is the case with regions 22 of the thyristor 10. The same problem applies to prior art thyristor 24 of Figure 2 illustrating a modification of the thyristor 10, above. The thyristor 24 has an active base region comprising a lightly doped N⁻ portion 25 and a more heavily doped N portion 27. As is known in the art, the presence of the more heavily doped N portion 27 between the N⁻ portion 25 and P⁺ emitter regions 28 enables the width of the active base region of the device to be reduced.

It is the object of the present invention to provide a semiconductor device according to the classifying portion of claim 1 which enables rapid removal of majority carries from the active base region thereof during turn-off.

According to the invention this object is solved by the advantageous features as indicated in the characterizing portion of claim 1. Dependent claims 2 to 12 relate to particular embodiments of the invention.

A method of fabricating a semiconductor device according to the invention is the subject matter of claims 13 to 24.

In the following the present invention will be explained in more detail by describing the preferred embodiments thereof with reference to the accompanying drawing figures in which:

FIGURE 1 is a schematic, cross-sectional view of a portion of a prior art semiconductor device;

FIGURE 2 is a view similar to Figure 1, showing a prior art modification of the device of Figure 1;

FIGURE 3 is a schematic, cross-sectional view of a portion of a semiconductor device incorporating one embodiment of the present invention;

FIGURES 4A—4D are schematic, cross-sectional views illustrating steps in the fabrication of semiconductor devices according to the present invention;

Figure 5 is a schematic, cross-sectional view of a portion of a semiconductor device incorporating a further embodiment of the present invention;

FIGURE 6 is a view similar to Figure 5 illustrating a modification of the semiconductor device of Figure 5;

FIGURE 7 is a view also like Figure 5 illustrating a further modification of the semiconductor device of Figure 5; and

FIGURE 8 is a view also like Figure 5 illustrating a still further modification of the semiconductor device of Figure 5.

In Figure 3, a semiconductor device 30 comprising a thyristor in accordance with the invention is shown. The device 30 comprises a substrate 31 and an epitaxial layer 32, grown over the substrate 31. The substrate 31 comprises at least in part bulk material and it preferably is comprised entirely of a bulk wafer. The substrate 31 comprises a first region 34 and second regions 35. The first region 34 is doped P-type and has a doping concentration at least about $5 \times 10^{17}$ dopant atoms per cubic centimeter, and preferably about $10^{18}$ dopant atoms per cubic centimeter. The second regions 35 are doped N-type and have a doping concentration at least as high as the doping concentration of the first region 34, and which preferably is about $10^{20}$ dopant atoms per cubic centimeter.

The epitaxial layer 32 comprises a third region 38, a fourth region 40, and fifth regions 41. The third region 38 separates the fourth and fifth regions 40 and 41 from the substrate 31; and the fourth region 40 separates the fifth regions 41 from the third region 38. The third region 38 constitutes an active base region in the device 30, is doped N-type, and has a doping concentration substantially lower than that of the substrate first region 34, and which is preferably in the range from about $10^{13}$ to $10^{15}$ dopant atoms per cubic centimeter. As used herein in regard to doping concentration, "substantially" lower or higher means at least about one order of magnitude lower or higher. The third region 38 adjoins a first principal surface 42 of the substrate 31, which comprises in part a surface of the substrate first region 34, and, in further part, a surface of the substrate second regions 35. The epitaxial layer fourth region 40 is doped P-type and has a doping concentration substantially higher than the doping concentration of the third region 38. The fifth regions 41 are doped N-type and have a doping concentration substantially higher than the doping concentration of the fourth region 38.

The semiconductor device 30 is a three-terminal device with an anode 42 electrically connected to the substrate first region 34, a cathode 44 electrically connected to the epitaxial layer fourth region 40 and also to the first region 41, and a gate 45 electrically connected to the fourth region 40. As will be apparent to those skilled in the art, the gate 45 can be replaced by various other gate means for rendering the device 30 conductive between the anode and cathode 42 and 44.

The width of the third or active base region 38, in accordance with the invention, is capable of having a reduced dimension where the semiconductor device 30 only needs to block low voltages (as used herein). "low" means relative to the blocking voltage capability of the prior art thyristor 10, above. Further, in accordance with the invention, upon turn-off of the device 30 being initiated, majority carriers in the third region 38 (electrons, here) are rapidly transferred to the substrate first region 34, due to the presence of the substrate second regions 35 in the device 30. This is because the majority carriers, or electrons here, in the third region 38 are attracted to the highly doped N-type substrate second regions 35, due to the lower resistance thereof to electron current flow and to the attraction provided to electrons by a positive potential at the anode 40 during turn-off of the device 30. The second regions 35 thereupon serve as efficient injectors of electrons into the substrate first region 34, especially where the doping concentration of the second regions 35 exceeds that of the first region 34. The electrons thus injected into the first region 34 rapidly recombine with holes, which are the predominant or majority carriers in the $P^+$ region 34. Additionally, some of the electrons that enter the second regions 35 from the third region 38 combine with holes that, statistically speaking, enter the second regions 35 from the first region 34. The ultimate significance of the inventive semiconductor device 30 having the feature of rapid removal of majority carriers from an active base region thereof during turn-off of the device is that time required for turn-off to be completed is significantly reduced.

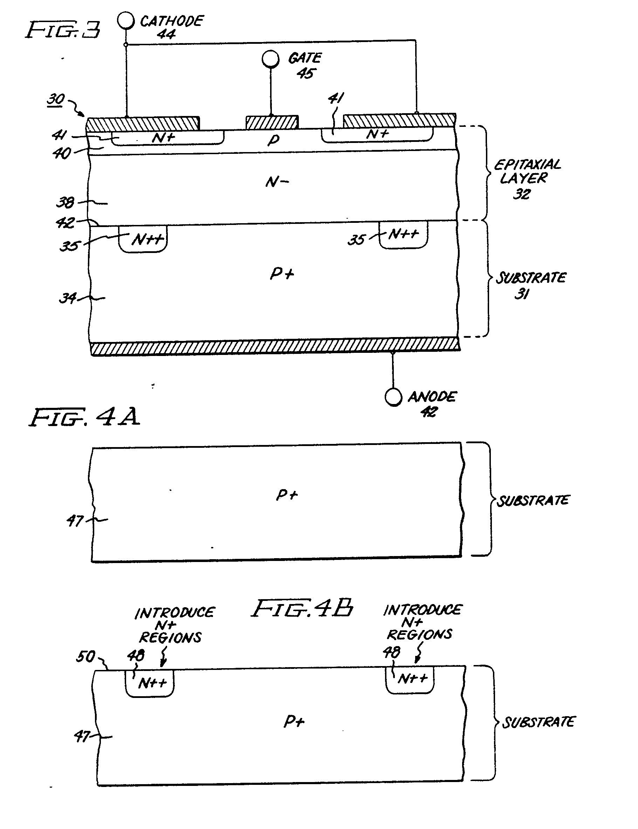

A preferred method of fabricating the above semiconductor device 30 is illustrated with respect to Figures 4A—4D. In Figure 4A, a bulk wafer 47, doped P-type and having a doping concentration at least about $5 \times 10^{17}$ dopant atoms per cubic centimeter, and preferably about $10^{18}$ dopant atoms per cubic centimeter, is provided. As indicated in Figure 4B, $N^{++}$ regions 48 are introduced through a first principal surface 50 of the substrate 47, preferably with a planar diffusion of phosphorus or antimony, or a combination thereof. The $N^{++}$ regions 48 can have various shapes, such as individual dots, stripes, or a singular, interconnected grid pattern, by way of example. Hereafter, the substrate second regions, or $N^{++}$ regions 48 in Figure 4B, are simply referred to in the plural sense.

Figure 4C illustrates an $N^-$ type epitaxial layer 51 grown on a substrate principal surface 50. The growing of the epitaxial layer 51 is preferably accomplished with vapor phase epitaxy, a known technique in the art. After the epitaxial layer 51 is grown, the remaining parts of the semiconductor device 30, indicated by phantom lines in Figure 4D, can be fabricated using well known techniques.

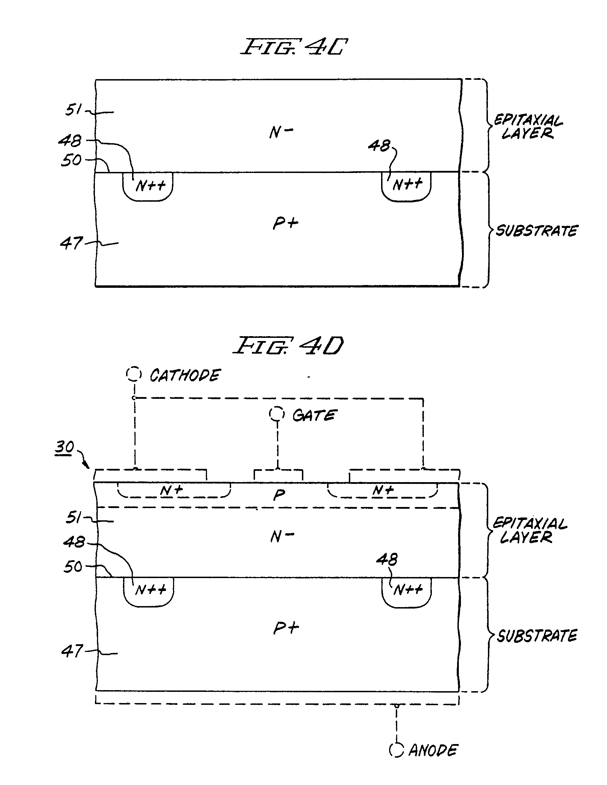

Turning to Figure 5, there is shown a further semiconductor device 52 incorporating the advantages of the present invention. Certain features of the device 52, which will become more apparent below, are disclosed in an earlier U.S. Patent Application not published prior to the present application and assigned to the present applicant.

In correspondence with the above semiconductor device 30, the semiconductor device 52 comprises a substrate 54 and an epitaxial layer 55 on the substrate 54. The substrate 54 comprises a first region 57 and second regions 58, which are suitably identical to the corresponding regions of the device 30. The epitaxial layer 55 comprises a third region 60, which constitutes an active base region of the device 52, and which is suitably doped the same as the corresponding region of the device 30. The epitaxial layer 55, further comprises fourth regions 61, fifth regions 62, and, preferably but optionally, as is discussed more fully below, sixth regions 63. The left-hand side of the device 52 as shown in Figure 5 is suitably symmetrical with the right-hand side, and, therefore, only the left-hand side is discussed in detail below.

The fourth region 61 adjoins the third region 60 and is separated from the substrate 54 by the third region 60; the fifth region 62 adjoins the third and fourth regions 60 and 61 and is separated from the substrate 54 by the third region 60; and the sixth region 63 adjoins the fourth and fifth regions 61 and 62 and is separated from the third region 60 by the fourth and fifth regions 61 and 62. The fifth region 62 has a free surface 65. As used herein, a "free surface" is a surface located at the exterior of the semiconductor body of the respective semiconductor device, which semiconductor body comprises a substrate with an epitaxial layer thereon. Thus, the free surface 65 of the fifth region 62 is a surface located at the exterior of the epitaxial layer 55. A first junction 66 between the third and fifth regions 60 and 62 has a portion terminating at an exterior surface of the epitaxial layer 55, such surface being the upper surface of the layer 55 in Figure 5. Like the first junction 66, a further, or second, junction 67 between the fifth and sixth regions 62 and 63 has a portion terminating at an exterior surface of the epitaxial layer 55, such surface also being the upper surface of the layer 55 in Figure 5. A gate 68 is separated from the epitaxial layer 55 by an insulative layer 70. The gate 68 covers an area on the epitaxial layer 55 including at least part of the fifth region free surface 65, from a location proximate the aforesaid terminated portion of the first junction 66, extending toward the cathode 71 (that is, toward the left in Figure 5), and to a location proximate the aforesaid terminated portion of the second junction 67. The gate 68, the insulative layer 70, and the fifth region 62 are so constructed and arranged that the fifth region 62 completes a current path for majority carriers in the third region 60 (electrons, here), which current path connects together the third region 60 and the sixth region 63, which is electrically connected to the cathode 71, upon suitable biasing of the gate 68.

What constitutes suitable biasing of the gate 68 depends upon the doping type of the fifth region 62, which can be either P-type or N-type. If it is P-type, the gate 68 would need to be biased with a positive voltage of sufficient magnitude to induce an inversion layer in the fifth region 62, immediately beneath the insulative layer 70, and extending between the third and sixth regions 60 and 63. Such an inversion layer is characterized by having a predominance of electrons therein. Accordingly, device current comprising electrons can flow from the cathode 71, through the $N^+$ sixth region 63, which advantageously has a low resistance to electron current, through the inversion layer within the fifth region 62, and into the N-type third region 60. Within the third region 60, which constitutes the active base region of the device 52, injected holes from the first region 57 electrically connected to the anode 72, recombine with electrons of the foregoing electron current originating from the cathode 71. With the fifth region 62 comprising P-type material, as just discussed, the semiconductor device 52 would be characterized in the art as a normally-off device, because without the gate 68 biased, the fifth region 62 does not offer a low resistance current path for the electrons between the third region 60 and the sixth region 63.

On the other hand, if the fifth region 62 comprises N-type material, electron current can flow therethrough in a current path between the sixth region 63 and the third region 60 without the presence of a biasing voltage on the gate 68. A semiconductor device 52 of this type would be characterized in the art as a normally-on device.

As briefly mentioned above, the presence of the sixth region 63 in the device 52 is preferable, but optional. If it is deleted, then the left-hand fifth region 62 in Figure 5 would extend to the left to at least a location 69, proximate the closest portion of the cathode 71. The gate 68 would then cover an area on the epitaxial layer 55 including at least part of the fifth region free surface 65, from a location proximate the aforesaid terminated portion of the junction 66, extending towards the cathode 71, and to at least the portion of the cathode 71 nearest to the aforesaid terminated portion of the junction 66. The gate 68, the insulative layer 70, and the fifth region 62 would be so constructed and arranged that the fifth region 62 completes a current path for majority carriers in the third region 60 which current path connects together the third region 60 and the cathode 71 upon suitable biasing of the gate 68, such suitable biasing being as discussed above.

A preferred method of fabricating the semiconductor device 52 follows the same steps as discussed above with respect to Figures 4A—4C. Fabrication of the parts in addition to the structure shown in Figure 4C, in order to arrive at the semiconductor device 52 of Figure 5, can be accomplished, in light of the present invention, using well known techniques.

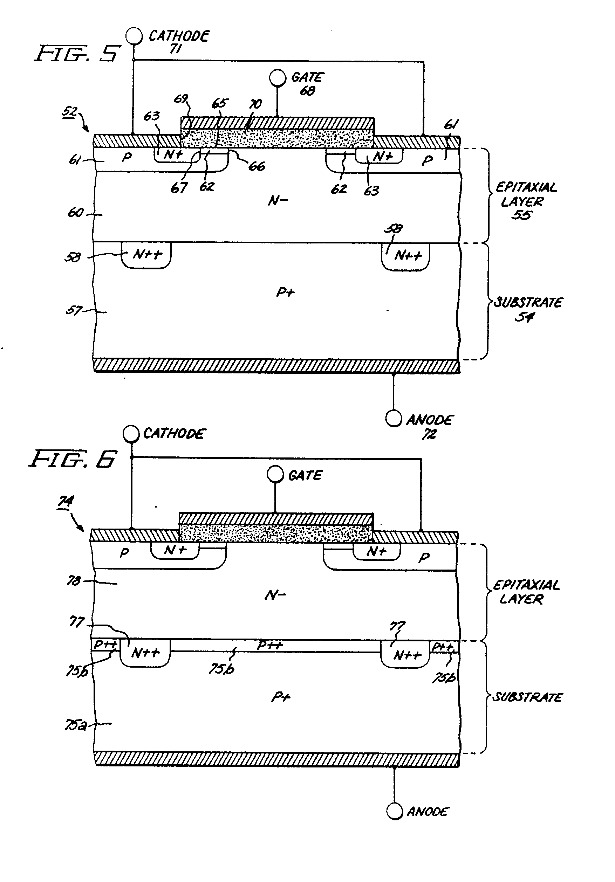

In Figure 6, a modification of the above semiconductor device 52 is illustrated as a semiconductor device 74. In the device 74, a substrate first region 75 comprises a major portion 75a and a minor portion or portions 75b, depending on the

0 080 044

configuration of second regions 77 (hereinafter "minor portion 75b"). The major portion 75a suitably is substantially alike the first region 57 of the device 52 shown in Figure 5. The minor portion 75b, however, has a doping concentration substantially higher than that of the major portion 75a. The doping of the minor portion 75b, however, should be less than that of the substrate second regions 77, in order that the upper portions of the second regions 77 remain N-type. By way of example, the minor portion 75b suitably is doped to about $10^{19}$ dopant atoms per cubic centimeter, and the second regions 77 are suitably doped to a concentration of $10^{20}$ dopant atoms per cubic centimeter. The presence of the $P^{++}$ minor portion 75b in the semiconductor device 74, during turn-off, improves the efficiency of electron injection from the second regions 77 into minor portion 75b, due to a tunneling effect which occurs in the interface regions between the second regions 77 and the minor portion 75b. The ultimate significance of increasing such injection efficiency is to reduce the time required to turn off the device 74. In order for the foregoing tunneling effect to occur, it is not necessary that the minor portion 75b adjoin the epitaxial layer third region 78, but it is advantageous to do so in order to improve hole injection from the first region 75 into the third region 78 during device operation in the "on" or conducting state. A $P^{++}$ first region minor portion, corresponding to the minor portion 75b of the semiconductor device 74, could also be incorporated into the semiconductor device 30, described above.

In fabricating the minor portion 75b of the semiconductor device 74, it is preferable that a blanket "introduction", preferably comprising a boron diffusion, of the $P^{++}$ minor portion 75b be made to the upper surface of a substrate, such as the substrate 47 of Figure 4A, or alternatively, to the substrate 47 of Figure 4B; in other words, either before or after the introduction of the $N^{++}$ regions 48 of Figure 4B, although after is preferred.

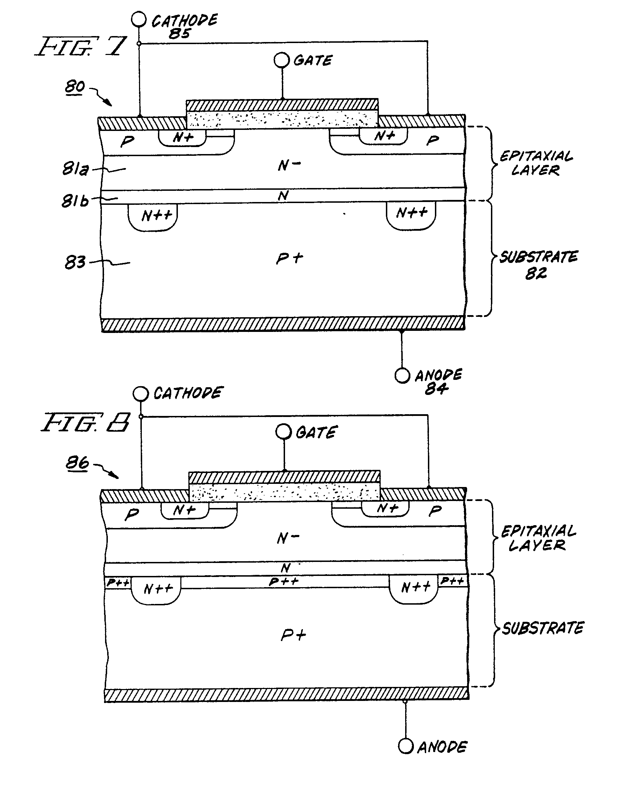

A further modification of the semiconductor device 52 of Figure 5 is shown as semiconductor device 80 of Figure 7. In device 80, a third region 81 comprises a major portion 81a, suitably doped to the same concentration as the third region 60 of the semiconductor device 52 of Figure 5, and a minor portion 81b, which has a doping concentration substantially higher than that of the major portion 81a but lower than that of the major portion of the substrate first region 83. By having the more highly doped minor portion 81b adjoining the upper surface of the substrate 82 and separating the major portion 81a from the substrate 82, the width (that is, the vertical dimension in Figure 7) of the third region 81, constituting an active base region of the device 80, advantageously can be less than the width of the third region 60 of the device 52 in order to decrease the voltage drop between the anode 84 and cathode 85 during forward conduction of the device 80, and, also, to reduce the required amount of semiconductor material. A N minor portion, corresponding to the minor portion 81b of the device 80, can also be incorporated into the semiconductor device 30, described above, whereby the width of the active base region thereof can be reduced.

In fabricating the epitaxial layer minor portion 81b, the substrate 47, shown in Figure 4B, is provided with a first epitaxial layer growth, doped to the desired concentration, grown on the top surface thereof. Thereafter, a second epitaxial layer growth is provided on top of the first epitaxial layer growth, thereby completing the epitaxial layer, having a lightly doped N-type portion, out of which the major portion 81a is formed, and a more heavily doped N-type portion which forms the minor portion 81b of the semiconductor device 80.

The modification of the semiconductor device 74 of Figure 6 and the modification of the semiconductor device 80 of Figure 7 can be incorporated into the same device, and, as such, would appear as semiconductor device 86 of Figure 8. The modifications of the device 86 could also be incorporated into the semiconductor device 30 of Figure 3.

From the foregoing it will be appreciated that the present invention provides a semiconductor device having the feature of rapid removal of majority carriers from an active base region thereof during turn-off of such device, whereby the time of turn-off thereof is reduced. Additionally, it can be appreciated that the invention provides a method of fabricating a semiconductor device having this feature. Additionally, further advantages and features of the present invention will be apparent to those skilled in the art. For example, the incorporation of the $N^{++}$ substrate second regions in the above semiconductor devices improves the breakdown voltages of the respective devices, due to the consequent reduction in injection efficiency of the $P^+$ substrate first region at low current levels. Further, the $N^{++}$ substrate second regions in the semiconductor device 30 of Figure 3 serve to reduce the sensitivity of the device to spurious turn-on due to noise and thermal currents generated in the semiconductor material thereof.

While only certain preferred features of the invention have been shown by way of illustration, many modifications and changes will occur to those skilled in the art. For example, an alternative introduction technique to the various diffusion implantations of the $N^{++}$ substrate second regions and $P^{++}$ minor portions is multiple doping ion implantation to reduce stresses in the $N^{++}$ substrate second regions and in the $P^{++}$ minor portions. Further, the invention applies to complimentary devices, wherein P-type regions are used in place of the N-type regions described herein, and vice-versa. In such a case, a boron diffusion should be used in place of a phosphorous or antimony diffusion, and vice-versa. Still further, the $N^{++}$ substrate second regions and $P^{++}$ minor portions could be fabricated by techniques other than the one specifically described herein.

For example, they could be fabricated by epitaxial growth on a bulk wafer.

**Claims**

1. A semiconductor device comprising
a) a first region (34; 57; 75; 83) being doped to one conductivity type and having a first doping concentration at least at a major poortion thereof;
b) a second region (35; 58; 77) extending into the first region, said second region being doped to the opposite conductivity type and having a second doping concentration which is at least as high as said first concentration;
c) at least a third (38; 60; 78; 81) and fourth region (40; 61) being provided on a common surface of said first and second regions, said third region being doped to said opposite conductivity type and said fourth region being doped to said one conductivity type;
d) a first electrode (42; 72; 84) electrically connected to a surface of said first region and
e) a second electrode (44; 71; 85) electrically connected to at least a surface of said fourth region; wherein
f) said third region comprises an active base region and separates said second region from said fourth region; characterized in that
A) said first region (34; 57; 75; 83) is essentially the semiconductor substrate (31; 54; 82) and comprises at least in part bulk type material, said first concentration being equal to at least about $5 \times 10^{17}$ dopant atoms per cubic centimeter;
B) said second region (35; 58; 77) is incorporated in said substrate such that a surface opposite to said common surface consists of said first region only, said opposite surface being connected to said first electrode;
C) said third (38; 60; 78; 81) and fourth (40; 61) regions are formed in an epitaxial layer (32, 55) deposited on said common surface of said first and second regions;
D) at least a major portion of said third region is doped to a third concentration substantially lower than said first concentration;
E) a major portion of said fourth region is doped to a fourth concentration substantially higher than said third concentration; whereby
majority carriers in said third region may be rapidly transferred to said first region by being attracted toward said second region during turn-off of said device, causing said second region to efficiently inject minority carriers into said first region and thereby combine with majority carriers therein.

2. Semiconductor device according to claim 1, characterized in that, said second region (35; 58; 77) has a doping concentration substantially higher than said first concentration.

3. Semiconductor device according to claim 1 or 2, characterized in that a minor portion (75b) of said first region (75) adjoining said second region (77) has a doping concentration substantially higher than said first concentration.

4. Semiconductor device according to claim 3, characterized in that, said first region minor portion (75b) additionally adjoins said epitaxial layer.

5. Semiconductor device according to one of the preceding claims 1 to 4, characterized in that a minor portion (81b) of said third region (81) adjoining said substrate common surface and separating a third region major portion (81a) from said substrate (82) is doped to a concentration substantially higher than said third concentration but lower than said first concentration.

6. Semiconductor device according to one of the preceding claims 1 to 5, characterized by
e) a fifth region (62) included in said epitaxial layer (55); said fifth region adjoining said third and fourth regions (60, 61), separated from said substrate (54) by said third region, and having a free surface located at the exterior of said epitaxial layer; a first junction (66) between said third and fifth regions having a portion terminating at the exterior surface of said epitaxial layer; and
f) a third electrode (68) separated from said epitaxial layer by an insulative layer (70), said third electrode covering an area on said epitaxial layer including at least part of said fifth region free surface from a location proximate said terminated portion of said first junction and extending towards said second electrode (71); said third electrode, said insulative layer, and said fifth region being so constructed and arranged that said fifth region completes a current path for majority carriers in said third region connecting together said third region and said second electrode upon suitable biasing of said third electrode.

7. Semiconductor device according to claim 6, characterized in that said fifth region (62) is doped to said one conductivity type, whereby the device is a normally-off device.

8. Semiconductor device according to claim 6, characterized in that said fifth region (62) is doped to said opposite conductivity type, whereby the device is a normally-off device.

9. Semiconductor device according to one of the preceding claims 6 to 8, characterized by a sixth region (63) doped to said opposite conductivity type, adjoining said fourth and fifth regions (61, 62), separated from said third region (60) by said fourth and fifth regions, and having a sixth doping concentration substantially higher than said fourth concentration; a second junction (67) between said fifth and sixth regions having a portion terminating at the exterior surface of said epitaxial layer (55); and wherein said area on said epitaxial layer covered by said third electrode (68) extends from said location to a location proximate said terminated portion of said second junction, whereby said sixth region is in said current path connecting together said third region and said second electrode (71).

10. Semiconductor device according to one of the preceding claims 1 to 5, characterized in that
e) said epitaxial layer (32) comprises a fifth region (41),
said fifth region being doped to said opposite conductivity type, adjoining said fourth region (40), being separated from said third region (38) by said fourth region, and having a fifth doping concentration substantially higher than said fourth concentration; and that

f) said second electrode (44) is electrically connected to said epitaxial layer fifth region.

11. Semiconductor device according to claim 10, characterized by a gate means (45) to render the device conductive between said first and second electrodes (42, 44).

12. Semiconductor device according to one of the preceding claims 1 to 11, characterized in that said one conductivity type is P-type and second opposite conductivity type is N-type.

13. A method of fabricating a semiconductor device according to claim 1, comprising the steps of:

a) providing a semiconductor substrate (47) comprising a bulk wafer doped to one conductivity type, and having a first doping concentration equal to at least about $5 \times 10^{17}$ dopant atoms per cubic centimeter;

b) introducing through part of a first principal surface (50) of said substrate at least one first region (48) of said opposite conductivity type; said first region having a second doping concentration which is at least as high as said first concentration; and

c) epitaxially growing a layer (51) of semiconductor material of said opposite conductivity type upon said substrate principal surface; a major portion of said epitaxial layer having a third doping concentration substantially lower than said first concentration.

14. The method according to claim 13, characterized in that said step of epitaxially growing a layer comprises first epitaxially growing a minor portion of said epitaxial layer on said substrate principal surface and then epitaxially growing said major portion of said epitaxial layer on said minor portion, said minor portion having a fourth doping concentration substantially higher than said third concentration.

15. The method according to claim 13 or 14, characterized by a step of introducing through said substrate principal surface a second region of said one conductivity type having a fifth doping concentration substantially higher than said first doping concentration.

16. The method according to claim 15, characterized in that said step of introducing said second region comprises a blanket introducing over a substantial portion of said substrate principal surface.

17. The method according to claim 16, characterized in that said step of introducing said second region occurs subsequent to said step of introducing said first region.

18. The method according to one of the preceding claims 15 to 17, characterized in that said step of introducing said second region comprises a diffusion.

19. The method according to claim 18, characterized in that said diffusion comprises a boron diffusion.

20. The method according to one of the claims 15 to 17, characterized in that said step of introducing said second region comprises multiple doping ion implantation.

21. The method according to one of the claims 13 to 20, characterized in that said step of introducing said first region comprises a planar diffusion.

22. The method according to claim 21, characterized in that said planar diffusion comprises one of the group consisting of a phosphorus diffusion, an antimony diffusion, or a phosphorus and antimony diffusion.

23. The method according to one of the claims 13 to 20, characterized in that said step of introducing said first region comprises multiple doping ion implantation.

24. The method according to one of the claims 13 to 23, characterized in that said one conductivity type is P-type and said opposite conductivity type is N-type.

**Patentansprüche**

1. Halbleiterbauelement mit

a) einer ersten Zone (34; 57; 75; 83), die zu einem ersten Leitfähigkeitstyp dotiert ist und eine erste Dotierkonzentration in zumindest einem größeren Teil derselben besitzt,

b) einer zweiten Zone (35; 58; 77), die sich in die erste Zone erstreckt, zu dem entgegengesetzten Leitfähigkeitstyp dotiert ist und eine zweite Dotierkonzentration aufweist, die mindestens so hoch wie die erste Konzentration ist,

c) zumindest einer dritten (38; 60; 78; 81) und vierten Zone (40; 61), die auf einer gemeinsamen Oberfläche der ersten und zweiten Zone vorgesehen sind, wobei die dritte Zone zu dem entgegengesetzten Leitfähigkeitstyp und die vierte Zone zu dem ersten Leitfähigkeitstyp dotiert ist,

d) einer ersten Elektrode (42; 72; 84), die elektrisch mit einer Oberfläche der ersten Zone verbunden ist, und

e) einer zweiten Elektrode (44; 71; 85), die zumindest mit einer Oberfläche der vierten Zone elektrisch verbunden ist, wobei

f) die dritte Zone eine aktive Basiszone aufweist und die zweite Zone von der vierten Zone trennt,

dadurch gekennzeichnet, daß

A) die erste Zone (34; 57; 75; 83) im wesentlichen das Halbleitersubstrat (31; 54; 82) bildet und zumindest teilweise volumenartiges Material aufweist, wobei die erste Konzentration zumindest etwa gleich $5 \times 10^{17}$ Dotieratome pro Kubikzentimeter beträgt,

B) die zweite Zone (35; 58; 77) in das Substrat derart eingebaut ist, daß eine der gemeinsamen Oberfläche entgegengesetzte Oberfläche lediglich aus der ersten Zone besteht, wobei die entgegengesetzte Oberfläche mit der ersten Elektrode verbunden ist,

C) die dritte (38; 60; 78; 81) und vierte (40; 61) Zone in einer Epitaxialschicht (32; 55) ausgebildet sind, die auf der gemeinsamen Oberfläche der ersten und zweiten Zone aufgebracht ist,

D) zumindest ein größerer Teil der dritten Zone zu einer dritten Konzentration dotiert ist, die im wesentlichen niedriger als die erste Konzentration ist,

E) ein größerer Teil der vierten Zone zu einer vierten Konzentration dotiert ist, die im wesentlichen höher als die dritte Konzentration ist, wobei

F) Majoritätsträger in der dritten Zone schnell in die erste Zone dadurch übertragen werden können, daß sie während des Abschaltens des Bauteils zur zweiten Zone hin angezogen werden, wodurch erreicht wird, daß die zweite Zone wirkungsvoll Minoritätsträger in die erste Zone injiziert, die sich dadurch mit darin befindlichen Majoritätsträgern verbinden.

2. Halbleiterbauelement nach Anspruch 1, dadurch gekennzeichnet, daß die zweite Zone (35; 58; 77) eine Dotierkonzentration aufweist, die im wesentlichen höher als die erste Konzentration ist.

3. Halbleiterbauelement nach Anspruch 1 oder 2, dadurch gekennzeichnet, daß ein kleinerer Teil (75b) der ersten Zone (75), der an die zweite Zone (77) angrenzt, eine Dotierkonzentration hat, die im wesentlichen höher als die erste Konzentration ist.

4. Halbleiterbauelement nach Anspruch 3, dadurch gekennzeichnet, daß der kleinere Teil (75b) der ersten Zone zusätzlich an die Epitaxialschicht angrenzt.

5. Halbleiterbauelement nach einem der vorhergehenden Ansprüche 1 bis 4, dadurch gekennzeichnet, daß ein kleinerer Teil (81b) der dritten Zone (81), der an die gemeinsame Oberfläche des Substrats angrenzt und einen größeren Teil (81a) der dritten Zone von dem Substrat (82) trennt, zu einer Konzentration dotiert wird, die im wesentlichen höher als die dritte Konzentration, aber niedriger als die erste Konzentration ist.

6. Halbleiterbauelement nach einem der vorhergehenden Ansprüche 1 bis 5, gekennzeichnet durch

e) eine in der Epitaxialschicht (55) eingeschlossene fünfte Zone (62), die an die dritte und vierte Zone (60, 61) angrenzt, von dem Substrat (54) durch die dritte Zone getrennt ist und eine freie Oberfläche besitzt, die an der Außenseite der Epitaxialschicht liegt, einen ersten Übergang (66) zwischen der dritten und fünften Zone mit einem an der äußeren Oberfläche der Epitaxialschicht endenden Teilbereich, und

f) einer von der Epitaxialschicht durch eine Isolationsschicht (70) getrennte dritte Elektrode (68), die eine Fläche auf der Epitaxialschicht bedeckt, die zumindest einen Teil der freien Oberfläche der fünften Zone von einer Stelle nahe dem endenden Teilbereich des ersten Überganges aus umfaßt und sich zur zweiten Elektrode (71) hin erstreckt, wobei die dritte Elektrode, die Isolationsschicht und die fünfte Zone derart aufgebaut und angeordnet sind, daß die fünfte Zone einen Strompfad für Majoritätsträger in der dritten Zone vervollständigt, indem die dritte Zone und die zweite Elektrode auf eine geeignete Vorspannung an der dritten Elektrode hin miteinander verbunden werden.

7. Halbleiterbauelement nach Anspruch 6, dadurch gekennzeichnet, daß die fünfte Zone (62) zum ersten Leitfähigkeitstyp dotiert ist, wobei das Bauteil selbstsperrend ist.

8. Halbleiterbauelement nach Anspruch 6, dadurch gekennzeichnet, daß die fünfte Zone (62) zu dem entgegengesetzten Leitfähigkeitstyp dotiert ist, wobei das Bauteil selbstsperrend ist.

9. Halbleiterbauelement nach einem der vorhergehenden Ansprüche 6 bis 8, dadurch gekennzeichnet, daß eine zu der entgegengesetzten Leitfähigkeit dotierte sechste Zone (63) vorgesehen ist, die an die vierte und fünfte Zone (61, 62) angrenzt, von der dritten Zone (60) durch die vierte und fünfte Zone getrennt ist und eine sechste Konzentration aufweist, die im wesentlichen höher als die vierte Konzentration ist, daß ein zweiter Übergang (67) zwischen der fünften und sechsten Zone vorgesehen ist, der einen an der äußeren Oberfläche der Epitaxialschicht (55) endenden Endbereich hat, und daß die von der dritten Elektrode (68) bedeckte Fläche auf der Epitaxialschicht sich von der Stelle bis zu einer Stelle nahe dem endenden Endbereich des zweiten Übergangs erstreckt, wobei die sechste Zone in dem Strompfad liegt, der die dritte Zone und die zweite Elektrode (71) verbindet.

10. Halbleiterbauelement nach einem der vorhergehenden Ansprüche 1 bis 5, dadurch gekennzeichnet, daß

e) die Epitaxialschicht (32) eine fünfte Zone (41) aufweist, die zu dem entgegengesetzten Leitfähigkeitstyp dotiert ist, an die vierte Zone (40) angrenzt, von der dritten Zone (38) durch die vierte Zone getrennt ist und eine fünfte Dotierkonzentration aufweist, die im wesentlichen höher als die vierte Konzentration ist, und daß

f) die zweite Elektrode (44) elektrisch mit der fünften Zone der Epitaxialschicht verbunden ist.

11. Halbleiterbauelement nach Anspruch 10, gekennzeichnet durch eine Gate-Vorrichtung (45), die das Bauteil zwischen der ersten und zweiten Elektrode (42, 44) leitend macht.

12. Halbleiterbauelement nach einem der vorhergehenden Ansprüche 1 bis 11, dadurch gekennzeichnet, daß der erste Leitfähigkeitstyp der P-Typ und der zweite entgegengesetzte Leitfähigkeitstyp der N-Typ ist.

13. Verfahren zum Herstellen eines Halbleiterbauelements nach Anspruch 1 mit den Schritten:

a) Vorsehen eines Halbleitersubstrats (47), mit einem volumenhaften Halbleiterplättchen, das zu einem ersten Leitfähigkeitstyp dotiert ist und eine erste Dotierkonzentration aufweist, die zumindest etwa gleich $5 \times 10^{17}$ Dotieratome pro Kubikzentimeter beträgt,

b) Erzeugen zumindest einer ersten Zone (48) des entgegengesetzten Leitfähigkeitstyps auf einem Teil einer ersten Hauptoberfläche (50) des Substrats, wobei die erste Zone eine zweite Dotierkonzentration aufweist, die zumindest so hoch wie die erste Konzentration ist, und

c) epitaktisches Aufwachsen einer Schicht (51) aus Halbleitermaterial des entgegengesetzten Leitfähigkeitstyps auf der Hauptoberfläche des Substrats, wobei ein größerer Teil der Epitaxialschicht eine dritte Dotierkonzentration aufweist, die im wesentlichen niedriger als die erste Konzentration ist.

14. Verfahren nach Anspruch 13, dadurch gekennzeichnet, daß der Schritt des epitaktischen Aufwachsens einer Schicht zunächst ein epitaktisches Aufwachsen eines kleineren Teils der Epitaxialschicht auf der Hauptoberfläche des Substrats und darauf ein epitaktisches Aufwachsen des größeren Teils der Epitaxialschicht auf dem kleineren Teil umfaßt, wobei der kleinere Teil eine vierte Dotierkonzentration aufweist, die im wesentlichen höher als die dritte Konzentration ist.

15. Verfahren nach Anspruch 13 oder 14, dadurch gekennzeichnet, daß in einem Schritt auf der Hauptoberfläche des Substrats eine zweite Zone des ersten Leitfähigkeitstyps mit einer fünften Dotierkonzentration erzeugt wird, die im wesentlichen höher als die erste Dotierkonzentration ist.

16. Verfahren nach Anspruch 15, dadurch gekennzeichnet, daß bei dem Schritt des Erzeugens der zweiten Zone eine Mantelschicht ausgebildet wird, die sich über einen wesentlichen Teil der Hauptoberfläche des Substrats erstreckt.

17. Verfahren nach Anspruch 16, dadurch gekennzeichnet, daß der Schritt des Erzeugens der zweiten Zone im Anschluß an den Schritt des Erzeugens der ersten Zone erfolgt.

18. Verfahren nach einem der vorhergehenden Ansprüche 15 bis 17, dadurch gekennzeichnet, daß der Schritt des Erzeugens der zweiten Zone eine Diffusion umfaßt.

19. Verfahren nach Anspruch 18, dadurch gekennzeichnet, daß die Diffusion eine Bordiffusion umfaßt.

20. Verfahren nach einem der Ansprüche 15 bis 17, dadurch gekennzeichnet, daß der Schritt des Erzeugens der zweiten Zone eine Mehrfach-Ionenimplantationsdotierung umfaßt.

21. Verfahren nach einem der Ansprüche 13 bis 20, dadurch gekennzeichnet, daß der Schritt des Erzeugens der ersten Zone eine Planardiffusion umfaßt.

22. Verfahren nach Anspruch 21, dadurch gekennzeichnet, daß die Planardiffusion eine Phosphordiffusion, eine Antimondiffusion oder eine Phosphor- und Antimondiffusion umfaßt.

23. Verfahren nach einem der Ansprüche 13 bis 20, dadurch gekennzeichnet, daß der Schritt des Erzeugens der ersten Zone eine Mehrfach-Ionenimplantationsdotierung umfaßt.

24. Verfahren nach einem der Ansprüche 13 bis 23, dadurch gekennzeichnet, daß der erste Leitfähigkeitstyp der P-Typ und der entgegengesetzte Leitfähigkeitstyp, der N-Typ ist.

**Revendications**

1. Dispositif semiconducteur comprenant:

a) une première région (34, 57, 75, 83) dopée selon un premier type de conductivité et ayant une première concentration de dopage au niveau d'au moins une partie principale;

b) une seconde région (35, 58, 77) s'étendant dans la première région, cette seconde région étant dopée selon le type de conductivité opposé et ayant une seconde concentration de dopage qui est au moins aussi élevée que la première concentration;

c) au moins une troisième (36, 60, 78, 81) et une quatrième région (40, 61) prévue sur une surface commune des première et seconde régions, la troisième région étant dopée selon le type de conductivité opposé et la quatrième région étant dopée selon le premier type de conductivité;

d) une première électrode (42, 72, 84) électriquement connectée à la surface de ladite première région; et

e) une seconde électrode (44, 71, 85) électriquement connectée à au moins une surface de la quatrième région, dans lequel:

f) la troisième région comprend une région de base active et sépare la seconde région de la quatrième région;

caractérisé en ce que:

A) la première région (34, 57, 75, 83) est essentiellement le substrat semiconducteur (31, 54, 82) et comprend au moins partiellement un matériau de type massif, la première concentration étant égale à au moins $5 \times 10^{17}$ atomes dopants par centimètre cube;

B) la seconde région (35, 58, 77) est incorporée dans le substrat de sorte qu'une surface opposée à la surface commune comprend seulement la première région, la surface opposée étant connectée à la première électrode;

C) les troisième (38, 60, 78, 81) et quatrième (40, 61) régions sont formées dans une couche épitaxiale (32, 55) déposée sur la surface commune des première et seconde régions;

D) au moins une partie principale de la troisième région est dopée selon une troisième concentration sensiblement inférieure à la première concentration;

E) une partie principale de la quatrième région est dopée à une quatrième concentration sensiblement plus élevée que la troisième concentration; d'où il résulte que des porteurs majoritaires dans la troisième région peuvent être rapidement transférés vers la première région en étant attirés vers la seconde région pendant la coupure du dispositif, amenant la seconde région à injecter efficacement des porteurs minoritaires dans la première région et à se combiner ainsi avec les porteurs majoritaires qui s'y trouvent.

2. Dispositif semiconducteur selon la revendication 1, caractérisé en ce que la seconde région (35, 58, 77) présente une concentration de dopage sensiblement plus élevée que la première concentration.

3. Dispositif semiconducteur selon l'une des revendications 1 ou 2, caractérisé en ce qu'une partie mineure (75b) de la première région (75) rejoignant la seconde région (77) a une concentration de dopage sensiblement plus élevée que la première concentration.

4. Dispositif semiconducteur selon la revendication 3, caractérisé en ce que la partie mineure de la première région (75b) touche également la couche épitaxiale.

5. Dispositif semiconducteur selon l'une des revendications 1 à 4 précédentes, caractérisé en ce qu'une partie mineure (81b) de la troisième région (81) touchant la surface commune du substrat et séparant une partie principale de la troisième région (81a) du substrat (82) est dopée selon une concentration sensiblement plus élevée que la troisième concentration mais inférieure à la première concentration.

6. Dispositif semiconducteur selon les revendications 1 à 5 précédentes, caractérisé par:

e) une cinquième région (62) incluse dans la couche épitaxiale (55); cette cinquième région touchant les troisième et quatrième régions (60, 61), séparées du substrat (54) par la troisième région et ayant une surface libre disposée à l'extérieur de la couche épitaxiale; une première jonction (66) entre les troisième et cinquième régions ayant une partie se terminant au niveau de la surface externe de la couche épitaxiale; et

f) une troisième électrode (68) séparée de la couche épitaxiale par une couche isolante (70), cette troisième électrode recouvrant une surface de la couche épitaxiale comprenant au moins une partie de la surface libre de la cinquième région par rapport à un emplacement proche de la partie terminale de la première jonction et s'étendant vers la seconde électrode (71); la troisième électrode, la couche isolante et la cinquième région étant constituées et agencées de sorte que la cinquième région ferme un trajet de courant pour les porteurs majoritaires dans la troisième région, reliant ensemble la troisième région et la seconde électrode sous une polarisation convenable de la troisième électrode.

7. Dispositif semiconducteur selon la revendication 6, caractérisé en ce que la cinquième région (62) est dopée selon le premier type de conductivité, d'où il résulte que le dispositif est un dispositif normalement ouvert.

8. Dispositif semiconducteur selon la revendication 6, caractérisé en ce que la cinquième région (62) est dopée selon le type de conductivité opposé, d'où il résulte que le dispositif est un dispositif normalement fermé.

9. Dispositif semiconducteur selon l'une des revendications 6 à 8 précédentes, caractérisé par une sixième région (63) dopée selon le type de conductivité opposé, touchant les quatrième et cinquième régions (61, 62), séparée de la troisième région (60) par les quatrième et cinquième régions, et ayant une sixième concentration de dopage sensiblement plus élevée que la quatrième concentration; une seconde jonction (67) entre les cinquième et sixième régions ayant une partie terminale au niveau de la surface extérieure de la couche épitaxiale (55); et dans lequel ladite surface de la couche épitaxiale recouverte de la troisième électrode (68) s'étend à partir dudit emplacement vers un emplacement proche de la partie terminale de la seconde jonction, d'où il résulte que la sixième région se trouve dans le trajet de courant reliant ensemble la troisième région et la seconde électrode (71).

10. Dispositif semiconducteur selon l'une des revendications précédentes 1 à 5, caractérisé en ce que:

e) la couche épitaxiale (32) comprend une cinquième région (41), cette cinquième région étant dopée selon le type de conductivité opposé, touchant la quatrième région (40), étant séparée de la troisième région (38) par la quatrième région et ayant une cinquième concentration de dopage sensiblement plus élevée que la quatrième concentration; et en ce que

f) la seconde électrode (44) est électriquement connectée à la cinquième région de couche épitaxiale.

11. Dispositif semiconducteur selon la revendication 10, caractérisé par un moyen d'électrode de commande (45) pour rendre le dispositif conducteur entre les première et seconde électrodes (42, 44).

12. Dispositif semiconducteur selon l'une des revendications précédentes 1 à 11, caractérisé en ce que le premier type de conductivité est le type P et le second type de conductivité opposée est le type N.

13. Procédé de fabrication d'un dispositif semiconducteur selon la revendication 1, comprenant les étapes suivantes:

a) prévoir un substrat semiconducteur (47) comprenant une tranche massive dopée selon un premier type de conductivité et ayant une première concentration de dopage égale à au moins $5 \times 10^{17}$ atomes dopants par centimètre cube;

b) introduire à travers une partie d'une première surface principale (50) du substrat au moins une première région (48) du type de conductivité opposé; la première région ayant une seconde concentration de dopage qui au moins aussi élevée que la première concentration; et

c) faire croître épitaxialement une couche (51) de matériau semiconducteur du type de conductivité opposé sur la surface principale du substrat; une partie principale de la couche épitaxiale ayant une troisième concentration de dopage sensiblement inférieure à la première concentration.

14. Procédé selon la revendication 13, caractérisé en ce que l'étape de croissance épitaxiale d'une couche comprend une première croissance épitaxiale d'une partie mineure de la couche épitaxiale sur la surface principale du substrat puis la croissance épitaxiale de ladite partie principale de la couche épitaxiale sur ladite partie mineure, la partie mineure ayant une quatrième concentration de dopage sensiblement plus élevée que la troisième concentration.

15. Procédé selon l'une des revendications 13 ou 14, caractérisé par une étape d'introduction à travers la surface principale du substrat d'une seconde région du premier type de conductivité ayant une cinquième concentration de dopage sensiblement plus élevée que la première concentration de dopage.

16. Procédé selon la revendication 15, caractérisé en ce que l'étape d'introduction de la seconde région comprend une introduction uniforme sur une partie notable de la surface principale du substrat.

17. Procédé selon la revendication 16, caractérisé en ce que ladite étape d'introduction de la seconde région prend place après l'étape d'introduction de la première région.

18. Procédé selon l'une des revendications 16 à 17 précédentes caractérisé en ce que l'étape d'introduction de la seconde région comprend une diffusion.

19. Procédé selon la revendication 18, caractérisé en ce que la diffusion comprend une diffusion de bore.

20. Procédé selon l'une des revendications 15 à 17 caractérisé en ce que l'étape d'introduction de la seconde région comprend des implantations multiples d'ions dopants.

21. Procédé selon l'une des revendications 13 à 20, caractérisé en ce que l'étape d'introduction de la première région comprend une diffusion planar.

22. Procédé selon la revendication 21, caractérisé en ce que la diffusion planar comprend l'une des diffusions dans le groupe consistant en une diffusion de phosphore, une diffusion d'antimoine, ou une diffusion de phosphore et d'antimoine.

23. Procédé selon l'une des revendications 13 à 20, caractérisé en ce que l'étape d'introduction de la première région comprend des implantations multiples d'ions dopants.

24. Procédé selon l'une des revendications 13 à 23, caractérisé en ce que le premier type de conductivité et le type P et le type de conductivité opposé est le type N.

# 0 080 044

FIG. 1
(PRIOR ART)

CATHODE 20

GATE 21

10

BULK WAFER 11

ANODE 18

FIG. 2
(PRIOR ART)

CATHODE

GATE

24

BULK WAFER

ANODE

1

FIG. 3

CATHODE 44

GATE 45

30

41

41

40

N+

P

N+

38

N−

42

35

N++

35

N++

34

P+

EPITAXIAL LAYER 32

SUBSTRATE 31

ANODE 42

FIG. 4A

47

P+

SUBSTRATE

FIG. 4B

INTRODUCE N+ REGIONS

INTRODUCE N+ REGIONS

50

48

48

N++

N++

P+

47

SUBSTRATE

## FIG. 4C

51
48
50
N−
N++
48
N++
P+
47

EPITAXIAL LAYER

SUBSTRATE

## FIG. 4D

○ CATHODE
○ GATE

30

N+
P
N+

51
48
50
N−
48

N++
N++

P+

47

EPITAXIAL LAYER

SUBSTRATE

○ ANODE

FIG. 5

CATHODE
71

GATE
68

52

63  69  65  70  61

61  P  N+  N+  P

67  62  66  62  63

60  N−

EPITAXIAL
LAYER
55

58  N++  58  N++

57  P+

SUBSTRATE
54

ANODE
72

FIG. 6

CATHODE

GATE

74

P  N+  N+  P

78  N−

77  77

P++  N++  P++  P++  N++  P++

75b  75b

75a  P+

EPITAXIAL
LAYER

SUBSTRATE

ANODE

**FIG. 7**

CATHODE 85

GATE

80

P | N+ | N− | N+ | P — EPITAXIAL LAYER

81a

81b — N

N++ | N++

83 — P+ — SUBSTRATE 82

ANODE 84

**FIG. 8**

CATHODE

GATE

86

P | N+ | N− | N+ | P — EPITAXIAL LAYER

N

P++ | N++ | P++ | N++ | P++

P+ — SUBSTRATE

ANODE